# EUROPEAN PATENT SPECIFICATION

(11) **EP 4 534 627 B1**
(45) Date of publication and mention of the grant of the patent: **20.05.2026**
(21) Application number: 24203794.3
(22) Date of filing: 01.10.2024
(51) Int. Cl.: C09K 11/02, C09K 11/70

(54) **QUANTUM DOT COMPOSITION, METHOD OF MANUFACTURING THE SAME, CURED PRODUCT THEREOF, AND DISPLAY DEVICE INCLUDING THE SAME**
QUANTENPUNKTZUSAMMENSETZUNG, VERFAHREN ZUR HERSTELLUNG DAVON, GEHÄRTETES PRODUKT DARAUS UND ANZEIGEVORRICHTUNG DAMIT
COMPOSITION DE POINTS QUANTIQUES, SON PROCÉDÉ DE FABRICATION, PRODUIT DURCI DE CELLE-CI ET DISPOSITIF D'AFFICHAGE COMPRENANT CELLE-CI

(30) Priority: 04.10.2023 KR 20230131930
(43) Date of publication of application: 09.04.2025
(73) Proprietor: Samsung Electronics Co., Ltd, Suwon-si, Gyeonggi-do 16677 (KR); Hansol Chemical Co., Ltd., Gangnam-gu Seoul 06169 (KR)
(72) Inventor: KOH, Sungjun, 16677 Suwon-si (KR); NAM, Kyoungmo, 06169 Seoul (KR); MUN, Ilju, 16677 Suwon-si (KR); BAE, Yunju, 06169 Seoul (KR); YU, Wonseok, 06169 Seoul (KR); YUN, Mihee, 06169 Seoul (KR)
(74) Representative: Appleyard Lees IP LLP

(56) References cited:
- KR-A- 20200 139 021
- US-A1- 2022 186 109

## Description

### BACKGROUND

### 1. Field

The disclosure relates to a quantum dot composition, a method of manufacturing the same, a cured product thereof, and a display device including the same, and more particularly, to a quantum dot composition for electrohydrodynamic inkjet printing, a method of manufacturing the same, a cured product thereof, and a display device including the same.

### 2. Description of the Related Art

Quantum dots or QDs, so-called semiconductor nanocrystals, produce various colors by emitting light of different wavelengths depending on particle size and without changing the type of material. Quantum dots are receiving much attention as next-generation light-emitting elements due to their ability to offer superior color purity and photostability compared to known luminescent materials.

Recently, quantum dots have become a new trend in the field of displays, such as TVs and LEDs as well as electronic devices in a complex form while being dispersed in a polymer matrix. Quantum dots, such as quantum dots formed of Cadmium-Selenium (CdSe) and Indium-Phosphors (InP), have been rapidly developed in terms of quantum yield and methods for synthesis thereof to obtain a quantum yield close to 100 % are being introduced. Based thereon, TVs including a quantum dot sheet are currently being commercialized.

In a next step of production, quantum dot TVs are expected to be provided with self-emissive versions rather than using a method of filtering with a color filter layer that have been developed by adding quantum dots to a color filter layer of a conventional LED TV (i.e., and by excluding pigments and dyes). A core technology of the development of quantum dot TVs is focused on the duration of maintenance of light efficiency of quantum dots during a process of forming pixels using quantum dots and during manufacturing processes.

Meanwhile, materials for color filters are required to have high sensitivity, adhesion to a substrate, chemical resistance, heat resistance, and the like. Color filters applied to conventional displays are manufactured by forming a desired pattern by a light exposure process to which a photomask is applied by using a photosensitive resist composition, and dissolving and removing non-exposed areas by a developing process. This process and others like it are often accompanied by increasing costs due to discarded materials.

Recently, a method of reducing the use of materials as much as possible and using materials only for desired areas has attracted much attention, rather than performing patterning by conventional spin coating or slip coating, to inhibit an increase in manufacturing costs caused by high-quality materials used in pixels. The most representative inkjet methods are a bubble jet method and a piezo method. Because materials are used only in desired pixels, unnecessary waste of materials may be inhibited by the inkjet method.

However, a quantum dot composition used for inkjet printing is required to have a viscosity of 100 centipoise (cps) or less, for example, 50 cps or less, and thus it is difficult to apply ink with a high viscosity over 100 cps or more thereto.

In order to overcome the shortcomings of such inkjet printing, electrohydrodynamic (EHD) inkjet printing that enables fine patterning has been developed. The EHD inkjet methods enable miniaturization and printing of ink according to an electric field by applying an electric potential difference between a nozzle ejecting the ink and a substrate.

As related art, a solution used for electrohydrodynamic printing methods has been disclosed in Korean Patent Application Publication No. 10-2020-0137977.

### SUMMARY

Provided are a quantum dot composition having high viscosity suitable for EHD inkjet method, excellent optical properties, and excellent inkjettability (jetting performance) as well as a manufacturing method thereof.

Also provided are a cured product of the quantum dot composition and a display device including the same.

Additional aspects will be set forth in part in the description which follows and, in part, will be apparent from the description, or may be learned by practice of the presented embodiments of the disclosure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a flow diagram illustrating a method of manufacturing a quantum dot composition; and
FIG. 2 is a schematic diagram illustrating a light-emitting device of a display device including a quantum dot composition.

### DETAILED DESCRIPTION

The disclosure now will be described more fully hereinafter with reference to the accompanying drawing, in which various embodiments are shown. This disclosure may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Throughout the disclosure, the expression "at least one of a, b or c" indicates only a, only b, only c, both a and b, both a and c, both b and c, all of a, b, and c, or variations thereof.

Unless otherwise defined, all terms (including technical and scientific terms) used herein have the same meaning as commonly understood by one or ordinary skill in the art to which this application belongs. Also, it will be further understood that terms, such as those defined in commonly used dictionaries, will not be interpreted in an idealized or overly formal sense unless expressly so defined herein.

In addition, throughout the specification, the term "including" an element specifies the presence of the stated element, but does not preclude the presence or addition of one or more elements, unless otherwise stated.

In addition, as used herein, the term "(meth)acrylate" refers to acrylate and methacrylate, the term "(meth)acrylic" refers to acrylic and methacrylic, and the term "(meth)acryloyl" refers to acryloyl and methacryloyl.

In addition, as used herein, the term "monomer" has the same meaning as "monomer". In the disclosure, a monomer is distinguished from an oligomer and a polymer and refers to a compound having a weight average molecular weight of 1,000 or less. As used herein, the term "photopolymerizable monomer" refers to a group involved in polymerization, e.g., (meth)acrylate group.

As used herein, the term "substituted" refers to replacement of a hydrogen of a compound or functional group with a substituent selected from a C1-C30 alkyl group, a C2-C30 alkenyl group, a C2-C30 alkynyl group, a C1-C30 alkoxy group, a C1-C30 heteroalkyl group, a C3-C30 heteroalkylaryl group, a C3-C30 cycloalkyl group, a C3-C15 cycloalkenyl group, a C6-C30 cycloalkynyl group, a C2-C30 heterocycloalkyl group, a halogen (-F, -Cl, -Br, or -I), a hydroxyl group (-OH), a nitro group (-NO₂), a cyano group (-CN), an ester group (-C(=O)OR), wherein R is a C1-C10 alkyl group or alkenyl group), an ether group (-O-R, wherein R is a C1-C10 alkyl group or alkenyl group), a carbonyl group (-C(=O)-R, wherein R is a C1-C10 alkyl group or alkenyl group), a carboxyl group (-COOH), and any combination thereof.

As used herein, the term "organic group" refers to a linear or branched C1-C30 alkyl group, a linear or branched C2-C30 alkenyl group, or a linear or branched C2-C30 alkynyl group. In addition, the alkyl group, the alkenyl group, and the alkynyl group may be substituted or unsubstituted.

As used herein, the term "alkyl" refers to a monovalent substituent derived from linear or branched saturated hydrocarbons having 1 to 40 carbon atoms. Examples thereof may include methyl, ethyl, propyl, isobutyl, sec-butyl, pentyl, iso-amyl, hexyl, or the like, but are not limited thereto. The term "alkylene group" as used herein refers to a divalent group having the same structure as the alkyl group derived from a linear or branched saturated hydrocarbon having 1 to 40 carbon atoms.

As used herein, the term "alkenyl" refers to a monovalent substituent having at least one carbon-carbon double bond and derived from a linear or branched unsaturated hydrocarbons having 2 to 40 carbon atoms. Examples thereof may include vinyl, allyl, isopropenyl, 2-butenyl, or the like, but are not limited thereto. The term "alkenylene group" as used herein refers to a divalent group having the same structure as the alkenyl group derived from a linear or branched unsaturated hydrocarbon that has at least one carbon-carbon double bond and 2 to 40 carbon atoms.

### <Quantum Dot Composition>

A quantum dot composition according to an embodiment of the disclosure may include a quantum dot, a photopolymerizable monomer, and an oligomer. The oligomer may include a compound including a carbon-carbon double bond and a compound including a thiol group.

The quantum dot composition according to an embodiment of the disclosure may be used for electrohydrodynamic inkjet printing, may have a viscosity of 5000 cps or less, for example, from about 100 cps to about 1000 cps, for example, from about 150 cps to about 600 cps.

Hereinafter, a chemical composition of the quantum dot composition will be described below.

### Quantum Dot

Quantum dots (QDs) that are nano-sized semiconductor materials may have various energy bandgaps according to size and composition, and accordingly emit light with various wavelengths.

The quantum dots may have a homogeneous single-layer structure; a multilayer structure such as a core-shell structure and a gradient structure; or any mixed structure thereof. In the core-shell structure, the shell may have multiple layers (e.g., core/shell/shell), wherein each layer may include different components, e.g., a metal (metalloid) oxide.

Quantum dots (QDs) may be selected freely from a Group 2-6 compound, a Group 3-5 compound, a Group 4-6 compound, a Group 4 element, a Group 4 compound, and any combination thereof. When the quantum dot has a core-shell structure, the core and the shell may be freely formed of components exemplarily described below.

For example, the Group 2-6 compound may be selected from a binary compound selected from CdO, CdS, CdSe, CdTe, ZnO, ZnS, ZnSe, ZnTe, HgS, HgSe, HgTe, MgSe, MgS, and any mixture thereof; a ternary element compound selected from CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and any mixture thereof; and a quaternary element compound selected from CdZnSeS, CdZnSeTe, CdZnSTe, CdHgSeS, CdHgSeTe, CdHgSTe, HgZnSeS, HgZnSeTe, HgZnSTe, and any mixture thereof.

As another example, the Group 3-5 compound may be selected from a binary compound selected from GaN, GaP, GaAs, GaSb, AIN, AIP, AlAs, AISb, InN, InP, InAs, InSb, and any mixture thereof; a ternary element compound selected from GaNP, GaNAs, GaNSb, GaPAs, GaPSb, AINP, AINAs, AINSb, AIPAs, AIPSb, InNP, InNAs, InNSb, InPAs, InPSb, and any mixture thereof; and a quaternary element compound selected from GaAINP, GaAINAs, GaAINSb, GaAIPAs, GaAIPSb, GalnNP, GalnNAs, GaInNSb, GalnPAs, GalnPSb, InAINP, InAINAs, InAINSb, InAIPAs, InAIPSb, and any mixture thereof.

As another example, the Group 4-6 compound may be selected from a binary compound selected from SnS, SnSe, SnTe, PbS, PbSe, PbTe, and any mixture thereof; a ternary element compound selected from SnSeS, SnSeTe, SnSTe, PbSeS, PbSeTe, PbSTe, SnPbS, SnPbSe, SnPbTe, and any mixture thereof; and a quaternary element compound selected from SnPbSSe, SnPbSeTe, SnPbSTe, and any mixture thereof.

As another example, the Group 4 element may be selected from Si, Ge, and any mixture thereof. The Group 4 compound may be selected from a binary compound selected from SiC, SiGe, and any mixture thereof.

As another example, the Group 4 compound may be, as an alloy-type compound, a ternary element compound selected from InZnP, and the like.

The above-described binary compounds, ternary element compounds, or quaternary element compounds may be present in particles at uniform concentrations or present in the same particle at partially different concentration distributions. In addition, the compounds may have a core-shell structure in which one quantum dot surround another quantum dot. An interface between the core and the shell may have a concentration gradient in which the concentration of an element present in the shell decreases toward the center.

The shape of the quantum dot is not particularly limited as long as the shape is commonly used in the art. For example, the shape of the quantum dot may be a spherical, rod-shaped, pyramidal, disc-shaped, multi-armlike, or cubic nanoparticle, a nanotube, a nanowire, a nanofiber, and a nanosheet particle.

In addition, the sizes of the quantum dots are not particularly limited and may be adjusted within a range commonly known in the art. For example, the quantum dots may have an average particle diameter D50 of about 2 nanometers (nm) to about 10 nm. By adjusting the particle diameter of the quantum dots to the range of about 2 nm to about 10 nm, light with desired color may be emitted. For example, when a particle diameter of a quantum dot core/shell including InP is from about 5 nm to about 6 nm, light with a wavelength of about 520 nm to about 550 nm may be emitted. Meanwhile, when a particle diameter of the quantum dot core/shell including InP is from about 7 nm to about 8 nm, light with a wavelength of about 620 nm to about 640 nm may be emitted. For example, as a blue-emitting QDs, non-cadmium (Cd)-based Group 3-5 compound QDs (e.g., InP, InGaP, InZnP, GaN, GaAs, and GaP) may be used.

In addition, the quantum dot may have a full width of half maximum (FWHM) of about 40 nm or less in a light emission wavelength spectrum. Within the range of the full width of half maximum, color purity or color reproduction may be improved. In addition, light emitted from the quantum dots proceeds in all directions, and thus optical viewing angle may be widened.

According to an embodiment of the disclosure, the amount of the quantum dots may be from about 1 weight percent (wt%) to about 60 wt%, for example, from about 20 wt% to about 60 wt% according to properties of the quantum dots based on a total weight of the quantum dot composition.

### Oligomer

In the quantum dot composition according to the disclosure, the oligomer includes a compound including a compound including a carbon-carbon double bond and a compound including a thiol group. For example, the oligomer may include two or more types of compounds including a carbon-carbon double bond, for example, one compound including two or three carbon-carbon double bonds per molecule and one compound including one carbon-carbon double bond per molecule.

In the case of including two or three carbon-carbon double bonds per molecule, the oligomer may have a molecular weight of about 200 g/mol to about 1000 g/mol, for example, about 200 grams per mole (g/mol) to about 800 g/mol, for example, about 200 g/mol to about 500 g/mol. For example, triallyl isocyanurate, or the like may be used.

In this regard, the compound including a carbon-carbon double bond may include one or more types of compounds including a phenol group, for example, the phenol group-containing compound may be a compound including one carbon-carbon double bond per molecule. In a post-process after curing the quantum dot composition, ligands on the surfaces of the quantum dots may be discharged in the form of gas (hereinafter, referred to as out gas) to cause product defects such as cracks and poor lamination in cured films, light-emitting elements, and display devices. When one or more phenol group-containing compounds are used, generation of out gas may be reduced. For example, phenol acrylate, or the like may be used.

The compound including a thiol group may include two to four functional groups, for example, two to four thiol groups per molecule, for example, two or three thiol groups per molecules. For example, glycol di(3-mercapto propionate), or the like may be used. Suitable functional groups include an ester (-C(=O)O-), an ether (-O-), a carbonyl (-C(=O)-), a carboxyl group (-C(=O)-OH), a sulfonyl (-SO2-), a sulfide (-S-), a sulfoxide (-SO-), an alkoxy group (CₙH₂ₙ₊₁O-), and a hydroxyl group (-OH).

A molar ratio of the compound including a carbon-carbon double bond to the compound including a thiol group may be from about 2.75:1 to about 5:1, for example, from about 2.75:1 to about 4:1, for example, from about 2.75:1 to about 3.5:1.

In addition, a molar ratio of the compound including two or three carbon-carbon double bonds per molecule to the compound including one carbon-carbon double bond per molecule may be from about 0.01:1 to about 1.5:1, for example, from about 0.1:1 to about 1.5:1, for example, from about 0.3:1 to about 1.2:1.

In the carbon-carbon double bond-containing compounds, the carbon-carbon double bonds may each independently include at least one selected from an allyl group, a vinyl group, a (meth)acrylic group, an isopropenyl group, or a 2-butenyl group, but are not limited thereto.

According to an embodiment of the disclosure, an amount of the oligomer may be from about 1 wt% to about 50 wt%, for example, from about 10 wt% to about 45 wt%, for example, from about 10 wt% to about 30 wt% based on a total weight of the quantum dot composition according to the properties of the quantum dot.

### Ligand

In the quantum dot composition according to the disclosure, the ligand serves to modify the surface of the quantum dot. Due to hydrophobic surface property, the quantum dot has a barrier to dispersion in the photopolymerizable monomer. Miscibility of the quantum dot with the photopolymerizable monomer may be improved by modifying the surface of the quantum dot with an appropriate ligand.

According to an embodiment of the disclosure, the ligand may include a first ligand represented by Formula 1 below and a second ligand including 3 to 40 carbon atoms and having a carboxyl group.

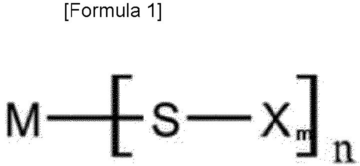

In Formula 1, M is a divalent to quadrivalent metal, m is an integer from 1 to 4, each X is independently a C3-C20 organic group and n is an integer from 2 to 4.

The first ligand may be a metal-thiol-based compound formed via reaction between a metal salt and a thiol-based compound.

In the first ligand, M is a divalent to quadrivalent metal. For example, the M, as a metal of Groups 2 to 4, may be Mg, Ca, Sc, Ti, V, Cr, Mn, Fe, Co, Ni, Cu, Zn, Ga, Ge, Sr, Y, Zr, Nb, Mo, Tc, Ru, Rh, Pd, Cd, In, or Sn. In Formula 1, n is determined by the valence of M and is an integer from 2 to 4.

In addition, in Formula 1, X may be independently a C3-C20 organic group. For example, X may be a C3-C20 alkylene group or alkenylene group including at least one functional group selected from an ester group (-C(=O)O-), an ether group (-O-), a carbonyl group (-C(=O)-), a carboxyl group (-C(=O)-OH), a sulfonyl group (-SO₂-), a sulfide group (-S-), a sulfoxide group (-SO-), an alkoxy group (CₙH₂ₙ₊₁O-), or a hydroxyl group (-OH). For example, the X may be a C4-C20 organic group including an ester group (-C(=O)O-).

In the first ligand, the thiol group having excellent affinity with the surface of each of the quantum dots may improve dispersity of the quantum dots in the photopolymerizable monomer. In addition, because the first ligand includes not only the thiol group, but also an ester group, an ether group, a carbonyl group, a carboxyl group, an alkoxy group, a cycloalkaline group, or a hydroxyl group, dispersity of the surface-modified quantum dots in a polar monomer having hydrophobicity may increase. In addition, the quantum dot composition including such quantum dots may have properties favorable to a display process (for example, low viscosity). Meanwhile, in the case of using a thiol-based compound having three or less carbon atoms, the surface of each of the quantum dots may be modified, but dispersity in a common solvent and a monomer may decrease due to high polarity of the surface-modified quantum dots.

The second ligand may include 3 to 40 carbon atoms and a carboxyl group. In addition, according to an embodiment of the disclosure, the second ligand may not include a thiol group.

According to an embodiment of the disclosure, the second ligand may be represented by Formula 2 below.

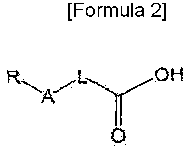

In Formula 2, L is a single bond or selected from a substituted or unsubstituted C1-C20 alkylene group and a substituted or unsubstituted C1-C20 alkylene group, A is a single bond, or a C1-C20 alkylene or alkenylene group including a functional group selected from an ester group (-C(=O)O-), an ether group (-O-), a carbonyl group (-C(=O)-), a sulfonyl group (-SO2-), a sulfide group (-S-), and a sulfoxide group (-SO-), and R is hydrogen, or selected from a substituted or unsubstituted C1-C20 alkyl group and a substituted or unsubstituted C1-C20 alkenyl group.

For example, in the second ligand, A may include an ester group (-COO-), an ether group (-O-), and any combination thereof. In addition, A may be a C2-C15 alkylene or alkenylene group, for example, a C2-C10 alkylene or alkenylene group.

In general, thiol-based ligands are known to have high reactivity with the surface of the quantum dot. However, a quantum dot composition including only a thiol-based ligand may not be suitable for compositions for inkjet printing due to problems such as harmful, small or poor storage stability because of increases in viscosities. The quantum dot composition according to the disclosure may have low viscosity and excellent storage stability due to the use of the first ligand including a thiol-based ligand and due to the use of the second ligand, which does not include a thiol-based ligand. In addition, the second ligand has excellent dispersity in a photopolymerizable monomer due to inclusion of the functional group such as an ester (-C(=O)O-) group, an ether (-O-) group, a carbonyl (-C(=O)-) group, and a carboxyl (-C(=O)-OH) group. Meanwhile, when the number of carbon atoms of the second ligand is greater than 16, surface modification of the quantum dot may not occur or dispersity in a common solvent or a monomer may deteriorate.

According to an embodiment of the disclosure, a molar ratio of the first ligand to the second ligand may be from about 1:30 to about 20:1, for example, from about 1:15 to about 10:1, for example, from about 1:8 to about 5:1, but is not limited thereto.

In addition, according to an embodiment of the disclosure, a mixing weight ratio of the quantum dot to the ligand may be from about 1:1 to about 1:20, for example, from about 1:1 to about 1: 10, for example, from about 1:5 to about 1:10. In this regard, the ligand refers to a sum of the first ligand and the second ligand.

### Photopolymerizable Monomer

In the quantum dot composition according to the disclosure, the photopolymerizable monomer may control the overall cross-linking density of a formulation in which the quantum dots (QDs) are dispersed, i.e., in a polymer matrix, to express the structure and overall physical properties of the matrix. In addition, flexibility and adhesion to other materials may be improved.

The photopolymerizable monomer may include an aromatic monomer including an aromatic ring such as a phenoxy group, a phenol group, or a phenyl group. For example, the aromatic monomer may be one selected from phenoxyethyl acrylate, phenoxyethyl methacrylate, ortho-phenyl phenoxyethyl acrylate, phenoxy benzylacrylate, benzyl acrylate, benzyl methacrylate, biphenylmethyl acrylate, bisphenol A diacrylate, bisphenol A dimethacrylate, bisphenol A ethoxylate diacrylate, bisphenol A glycerolate diacrylate, bisphenol F ethoxylate diacrylate, or any combination thereof. The photopolymerizable monomer may include one or more types of the aromatic monomers. The aromatic monomer may achieve the effect of improving light conversion efficiency due to a high refractive index of 1.50 or more.

In the disclosure, an amount of the aromatic monomer may be from about 1 wt% to about 20 wt%, for example, from about 3 wt% to about 15 wt%, based on a total weight of the quantum dot composition according to the quantum dot.

In addition, the photopolymerizable monomer may include a (meth)acrylate-based monomer. For example, the (meth)acrylate-based monomer may include at least one selected from a (meth)acrylic group, a vinyl group, or an allyl group. For example, 1,6-hexanediol diacrylate, 1,6-cyclohexanediol diacrylate, 2,2-dimethyl-1,3-propanediol diacylate, diethylene glycol diacrylate, dipropylene glycol diacrylate, 1,3-butylene glycol dimethacrylate, trimethylolpropane trimethacrylate, isobonyl acrylate, isobonyl methacrylate, tetrahydrofuryl acrylate, acryloyl morpholine, 2-phenoxyethyl acrylate, tripropylene glycol diacrylate, trimethylolpropane triacrylate, pentaerythritol mono(meth)acrylate, pentaerythritol di(meth)acrylate, pentaerythritol triacrylate, pentaerythritol trimethacrylate, dipentaerythritol hexaacrylate, dipentaerythritol hexamethacrylate, and the like may be used. These compounds may be used alone or in a mixture of two or more thereof. In the disclosure, as the (meth)acrylate-based monomer, 1,6-hexanediol diacrylate, may be suitable to obtain viscosity property of the quantum dot composition.

In the disclosure, an amount of the photopolymerizable monomer may be from about 1 wt% to about 60 wt%, for example, from about 3 wt% to about 50 wt%, based on a total weight of the quantum dot composition according to the quantum dot.

### Photoinitiator

In the quantum dot composition according to the disclosure, the photoinitiator is a component excited by a light source such as ultraviolet (UV) rays to serve to initiate photopolymerization, and any photopolymerization photoinitiators commonly available in the art may be used. For example, acetophenone-based compounds, benzophenone-based compound, thioxanthone-based compounds, benzoin-based compounds, triazine-based compounds, and oxime-based compounds may be used.

Non-limiting examples of the photoinitiator may include ethyl(2,4,6-trimethylbenzoyl)phenylphosphinate, Irgacure 184, Irgacure 369, Irgacure 651, Irgacure 819, Irgacure 907, benzionalkylether, benzophenone, benzyl dimethyl katal, hydroxycyclohexyl phenyl acetone, chloroacetophenone, 1,1- 1,1-dichloro acetophenone, diethoxy acetophenone, hydroxy acetophenone, 2-chloro thioxanthone, 2-ethylanthraquinone (2-ETAQ), 1-hydroxy- cyclohexyl-phenyl-ketone, 2-hydroxy-2-methyl-1-phenyl-1-propanone, 2-hydroxy-1-[4-(2-hydroxyethoxy)phenyl]-2-methyl-1-propanone, or methylbenzoylformate. These compounds may be used alone or in a combination of two or more thereof.

An amount of the photoinitiator may be appropriately adjusted within a range known in the art. For example, the amount of the photoinitiator may be from about 0.01 wt% to about 10 wt%, for example, from about 0.1 wt% to about 5 wt% based on a total weight of the quantum dot composition. Within the range of the amount of the photoinitiator, photopolymerization may be sufficiently performed without deterioration of physical properties of the matrix.

### Diffusing Agent

In the quantum dot composition according to the disclosure, a diffusing agent reflects light that is not absorbed by a light-converting material and allows the light-converting material to absorb the reflected light again. That is, the diffusing agent may increase light conversion efficiency by increasing the amount of light absorbed by the light-converting material.

The diffusing agent may be any diffusing agents well known in the art without limitation. The diffusing agent may be a solid or a dispersion in which the diffusing agent is dispersed.

Non-limiting examples of the diffusing agent used herein may include barium sulfate (BaSO₄), calcium carbonate (CaCO₃), titanium dioxide (TiO₂), zirconia (ZrO₂), or any combination thereof. In addition, an average particle diameter or shape of the diffusing agent is not particularly limited and may be selected from the configurations known in the art. For example, an average particle diameter (D50) may be from about 150 nm to about 250 nm, for example, from about 180 nm to about 230 nm. When the average particle diameter of the diffusing agent is within the range described above, light diffusion effect may be improved and light conversion efficiency may be increased.

An amount of the diffusing agent may be appropriately adjusted within a range known in the art. For example, the amount of the diffusion agent may be from about 0.01 wt% to about 10 wt%, for example, from about 0.1 wt% to about 5 wt%, based on a total weight of the quantum dot composition. Within the range of the amount of the diffusing agent, the effect of improving light conversion efficiency may be obtained without deterioration of physical properties of the matrix.

### Polymerization Inhibitor

In the quantum dot composition according to the disclosure, the polymerization inhibitor, as a material forming a low-reactivity radical or compound that cannot be involved in polymerization with a radical, may adjust reaction rate of photopolymerization.

The polymerization inhibitor may be any material known in the art without limitation. For example, the polymerization inhibitor may be a quinone-based compound, a phenol or aniline-based compound, an aromatic nitro and nitroso compound. For example, hydroquinone (HQ), methylhydroquinone (THQ), hydroquinone monomethyl ether (MEHQ) and hydroquinone mono ethylether (EEHQ) 1,4-benzoquinone (BQ), 2,5-diphenylbenzoquinone (DPBQ), methyl-1,4-benzoquinone (MBQ), phenyl-1,4-benzoquinone (PBQ); 2,6-di-tert-butyl-4-methylphenol (BHT), 2,6-diphenyl-4-octadecyloxyphenol, catechol; phenocyazine, bis(α-methylbenzyl)phenocyazine, 3,7-dioctylphenocyazine, bis(α,α-dimethylbenzyl)phenocyazine; dimethyldithiocarbamic acid, diethyldithiocarbamic acid, dipropyldithiocarbamic acid, dibutyldithiocarbamic acid, diphenyldithiocarbamic acid, and the like may be used. These compounds may be used alone or in a combination of two or more thereof.

An amount of the polymerization inhibitor may be appropriately adjusted within a range known in the art. For example, the amount of the polymerization inhibitor may be from about 0.01 wt% to about 2 wt%, for example, from about 0.05 parts by weight to about 1 part by weight, based on a total weight of the quantum dot composition.

### Other Additives

In addition to the above-described components, the quantum dot composition of the disclosure may further include any additives known in the art without limitation within a range not impairing the effect of the disclosure. Amounts of the additives may be appropriately adjusted within ranges known in the art.

Examples of the available additives may include a silane-based compound, a siloxane-based compound, an antioxidant, a polymerization inhibitor, a lubricant, a surface conditioning agent, a surfactant, an adhesion promotor, an antifoaming agent, a slip agent, a solvent, a humectant, a photostabilizer, an anti-stain agent, a softener, a thickener, and a polymer. These additives may be used alone or in a combination of two or more thereof.

The silane-based compound serves to provide adhesion to the matrix, and the siloxane-based compound serves to provide wetting properties. The silane-based compound and the siloxane-based compound may be any components known in the art without limitation.

The antioxidant is for inhibiting fading by heat or light and for preventing fading by various oxidizing gases such as ozone, reactive oxygen, NOx, and SOx (wherein X is an integer). In the disclosure, coloring of the matrix may be inhibited or a decrease in film thickness caused by decomposition may be reduced by adding the antioxidant. Examples of the antioxidant may include hydrazides, hindered amine-type antioxidants, nitrogen-containing heterocyclic mercapto compounds, thioether-based antioxidants, hindered phenol-based antioxidants, ascorbic acids, zinc sulfate, thiocyanates, thio-urea derivatives, saccharides, nitrites, sulfites, thiosulfates, and hydroxylamine derivatives.

A leveling agent may be included for improving adhesion in a composition by leveling the quantum dot composition such that the quantum dot composition is coated as a flat and smooth film. As the leveling agent, an acrylic compound, a silicone compound, and the like may be used alone or in a mixture of two or more thereof. For example, the leveling agent may include the polyether-modified polydimethylsiloxane and may have a structure in which a (meth)acryloyl group is located in the polyether chain.

The surfactant may be included for miscibility and coating uniformity of the quantum dot composition. The surfactant may be cationic, anionic, amphoteric, and nonionic surfactants well known in the art. For example, at least one of a fluorine-based surfactant, a silicone-based surfactant, or a fluorine-silicone-based surfactant may be used.

The photostabilizer, as a UV absorber, has the effect of improving weather resistance of the matrix. The softener is used to reduce occurrence of cracks in the dried polymer matrix and may improve impact resistance and bending resistance by reducing occurrence of cracks in a cured matrix.

### <Method of Manufacturing Quantum Dot Composition>

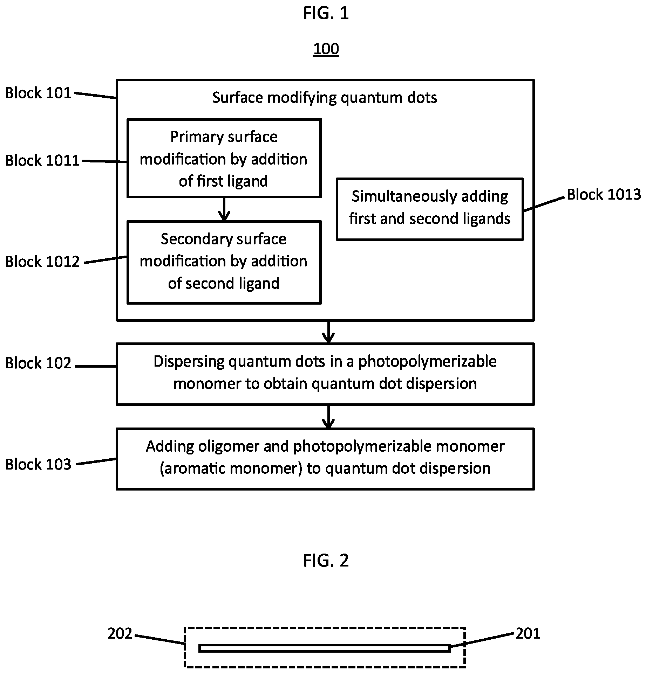

With reference to FIG. 1, a method 100 of manufacturing a quantum dot composition according to an embodiment of the disclosure may include surface-modifying quantum dots (block 101) and dispersing the quantum dots in a photopolymerizable monomer to obtain a quantum dot dispersion (block 102), and additionally adding an oligomer and a photopolymerizable monomer to the quantum dot dispersion (block 103), wherein the additionally added photopolymerizable monomer includes an aromatic monomer having an aromatic ring such as a phenoxy group, a phenol group, or a phenyl group.

The oligomer includes a compound including a carbon-carbon double bond and a compound including a thiol group, and the oligomer may be prepared by stirring and polymerizing at room temperature before being mixed with the quantum dot dispersion. The oligomer may further include a thermal initiator and a polymerization inhibitor.

The surface-modifying of the quantum dot of block 101 may include primary surface modification (block 1011) performed by adding a first ligand represented by Formula 1 below, and secondary surface modification (block 1012) performed by adding a second ligand including 3 to 40 carbon atoms and having a carboxyl group.

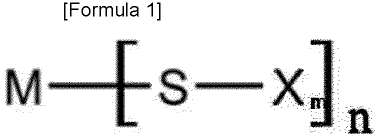

In Formula 1, M is a divalent to quadrivalent metal, m is an integer from 1 to 4, each X is independently a C3-C20 organic group and n is an integer from 2 to 4.

For example, after synthesizing each of the quantum dots, the first ligand is added to a solution including the synthetic quantum dots to perform the primary surface modification, followed by centrifugation to obtain the primarily surface-modified quantum dots. Then, the primarily surface-modified quantum dots are dispersed in the photopolymerizable monomer and the second ligand including 3 to 40 carbon atoms and having a carboxyl group is added thereto for secondary surface modification.

In this regard, the method of manufacturing quantum dots may be performed by using any method disclosed in a number of documents (e.g., high-temperature injection, method using a microfluidic reactor, and microwave irradiation).

Each of the quantum dots may be primarily surface-modified by adding the first ligand to a solution including the synthetic quantum dot and maintained at about 60°C and stirring the mixture for about 30 minutes to about 3 hours, and then secondarily surface-modified by adding the second ligand thereto and stirring the mixture for about 30 minutes to about 3 hours.

By performing the surface modification of each of the quantum dots in the two steps, formation of adducts produced by reaction between the first ligand and the second ligand may be prevented. On the contrary, in the case of simultaneously adding the first ligand and the second ligand to each of the quantum dots (block 1013), an adduct may be formed via thiol-ene reaction between the thiol group of the first ligand and acrylate of the second ligand. Such adducts may increase viscosity of the quantum dot composition while the surface-modified quantum dots are dispersed in the photopolymerizable monomer.

After modifying the surface of each of the quantum dots as described above, the surface-modified quantum dots may be obtained by centrifugation. In addition, the quantum dot dispersion may be prepared by dispersing the obtained surface-modified quantum dots in the photopolymerizable monomer.

Subsequently, the photopolymerizable monomer may further be added to the prepared quantum dot dispersion and the oligomer, and the polymerization inhibitor, the photoinitiator, and the diffusing agent may further be mixed therewith to prepare a quantum dot composition. In this regard, the additionally added photopolymerizable monomer may include at least one type of an aromatic monomer having an aromatic ring such as a phenoxy group, a phenol group, or a phenyl group, and an amount of the aromatic monomer may be from about 1 wt% to about 20 wt%, for example, from about 3 wt% to about 15 wt% based on a total weight of the quantum dot composition.

In addition, the photopolymerizable monomer is as described above in the quantum dot composition in a duplicate range.

### <Cured Product, Light-emitting Element, and Display Device>

With reference to FIG. 2, the disclosure may provide a cured product including the above-described quantum dot composition. The cured product according to the disclosure may have excellent optical properties, for example, a light absorption of 80 % or more. In addition, the cured product may have a light conversion rate of 35 % or more.

The cured product may be prepared by forming a pattern by applying the above-described quantum dot composition to a substrate by spin coating; and curing the pattern.

The disclosure provides a light-emitting element 201 including the above-described quantum dot composition. For example, a color filter is an optical component in the form of a thin film that extracts red, green, and blue lights on a pixel basis from white light emitted from a rear light source and realizes colors in a liquid crystal display.

The color filter may be manufactured by dyeing, pigment dispersion, printing, electrodeposition, and the like. In addition, the color filter including the quantum dot composition may be manufactured by inkjet printing. The inkjet printing may prevent unnecessary waste of materials because the materials are used only in desired pixels.

The disclosure also provides a display device 202 including the above-described quantum dot composition. In this regard, the display device may be a liquid crystal display (LCD) device, an electroluminescence (EL) display device, a plasma display device (PDP), a field emission display (FED) device, an organic light-emitting element (OLED), or the like, but is not limited thereto.

Hereinafter, the disclosure will be described in more detail with reference to the following examples. However, the following examples are merely presented to exemplify the disclosure, and the scope of the disclosure is not limited thereto.

### [Preparation Example 1] Preparation of First Ligand

1) About 280 g of poly(ethylene glycol)methyl ether 400 and about 50 g of mercaptosuccinic acid were reacted at about 100°C for about 12 hours. After completion of the reaction, the resultant was cooled to room temperature to obtain 330 g of bis-(methoxy polyethylene glycol)mercaptosuccinate-400).
2) 1.7 g of zinc chloride (ZnCl₂) and 32 g of bis-(methoxy polyethylene glycol)mercaptosuccinate-400) were added to 134.5 g of hexyl acetate in a round flask and dissolved at about 60 °C by stirring. Then, HCl was removed for 2 hours in a vacuum state to prepare a first ligand, i.e., Zn-bis-(methoxy polyethylene glycol)mercaptosuccinate-400.

### [Preparation Example 2] Preparation of Second Ligand

A compound represented by Formula B-1 was added to hexyl acetate in a round flask and stirred at room temperature for about 1 hour to prepare a second ligand, i.e., mono(2-acryloyloxyethyl) succinate.

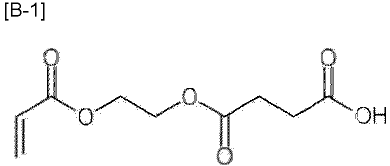

### [Preparation Example 3] Preparation of Quantum Dot (QD) Dispersion

1) 750 ml of an InZnP/ZnSe/ZnS (core/shell/shell) quantum dot dispersion solution (Hansol, quantum dot solid content of 20 wt%, hexyl acetate) was heated to about 60 °C in a nitrogen atmosphere while stirring. About 9 g of Zn-bis-(methoxy polyethylene glycol)mercaptosuccinate-400, as the prepared first ligand, was added thereto, followed by stirring to perform primary surface modification on the quantum dot.
2) About 30 g of mono(2-acryloyloxyethyl) succinate, as the prepared second ligand, was added to the solution including the primarily surface-modified quantum dot, followed by stirring for about 2 hours to perform secondary surface modification.
3) The solution including the surface-modified quantum dot was centrifuged twice with cyclohexane to obtain quantum dot powder and the powder was dispersed in 1,6-hexanediol diacrylate (MIWON) in a concentration of 60 wt% to prepare a QD dispersion.

### [Preparation Example 4] Preparation of Oligomer A

1 part by weight of 2,2'-azobis(2,4-dimethylvaleronitrile) and 0.1 parts by weight of methylhydroquinone were dissolved in 100 parts by weight of triallyl isocyanurate to prepare a crude solution A. 42.9 parts by weight of the crude solution, 28.6 parts by weight of phenol acrylate, and 28.6 parts by weight of glycol di(3-mercapto propionate) were mixed and stirred at room temperature for 1 hour. After the stirring, the temperature of a reactor was set to about 80 °C to prepare oligomer A by oligomer polymerization.

### <Example 1-1> Preparation of Quantum Dot Composition

After mixing 70 parts by weight of a surface-modified green quantum dot dispersion (Hansol, 60 wt% of quantum dot polymer: 40 wt% of 1,6-hexanediol diacrylate) with 14.5 parts by weight of oligomer A, the mixture was mixed with 5.4 parts by weight of 1,6-hexane diol diacrylate (MIWON), 3 parts by weight of phenoxyethyl acrylate (Green Chemical), 0.1 parts by weight of methylhydroquinone, 2 parts by weight of ethyl(2,4,6-trimethylbenzoyl)phenylphospinate as a photoinitiator, and 5 parts by weight of titanium dioxide as a diffusing agent to prepare a quantum dot composition.

### <Example 1-2>

A quantum dot composition was prepared in the same manner as in Example 1-1, except that 12.5 parts by weight of oligomer A and 5 parts by weight of phenoxyethyl acrylate were used.

### <Example 1-3>

A quantum dot composition was prepared in the same manner as in Example 1-1, except that 10.5 parts by weight of oligomer A and 7 parts by weight of phenoxyethyl acrylate were used.

### <Example 1-4>

A quantum dot composition was prepared in the same manner as in Example 1-1, except that 3 parts by weight of bisphenol A diacrylate was used instead of 3 parts by weight of phenoxyethyl acrylate.

### <Example 1-5>

A quantum dot composition was prepared in the same manner as in Example 1-2, except that 5 parts by weight of bisphenol A diacrylate was used instead of 5 parts by weight of phenoxyethyl acrylate.

### <Comparative Example 1-1>

A quantum dot composition was prepared in the same manner as in Example 1-1, except that 17.5 parts by weight of oligomer A was used instead of 14.5 parts by weight of oligomer A and 3 parts by weight of phenoxyethyl acrylate.

### <Comparative Example 1-2>

A quantum dot composition was prepared in the same manner as in Comparative Example 1-1, except that 10.5 parts by weight of oligomer A was used and 12.4 parts by weight of 1,6-hexanediol diacrylate was used.

### <Comparative Example 1-3>

A quantum dot composition was prepared in the same manner as in Comparative Example 1-1, except that 22.9 parts by weight of 1,6-hexanediol diacrylate was used instead of 17.5 parts by weight of oligomer A.

### <Example 2-1>

After mixing 46.5 parts by weight of a surface-modified red quantum dot composition (Hansol, 60 wt% of quantum dot polymer: 40 wt% of 1,6-hexanediol diacrylate), with 35.5 parts by weight of oligomer A, the mixture was mixed with 5.9 parts by weight of 1,6-hexanediol diacrylate, 5 parts by weight of bisphenol A diacrylate, 0.1 parts by weight of methylhydroquinone, 2 parts by weight of ethyl(2,4,6-trimethylbenxoyl)phenylphospinate as a photoinitiator, and 5 parts by weight of titanium dioxide as a light scattering agent to prepare a quantum dot composition.

### <Comparative Example 2-1>

A quantum dot composition was prepared in the same manner as in Example 2-1, except that 10.9 parts by weight of 1,6-hexanediol diacrylate was used instead of 5.9 parts by weight of 1,6-hexanediol diacrylate and 5 parts by weight of bisphenol A diacrylate.

### <Comparative Example 2-2>

A quantum dot composition was prepared in the same manner as in Comparative Example 2-1, except that 46.4 parts by weight of 1,6-hexanediol diacrylate was used instead of 35.5 parts by weight of oligomer A and 10.9 parts by weight of bisphenol A diacrylate.

The compositions of the examples and comparative examples are shown in Tables 1A, 1B and 1C below.

**Table 1A**

| | Category | Example 1-1 | Example 1-2 | Example 1-3 | Example 1-4 | Example 1-5 |
|---|---|---|---|---|---|---|
| Composition | QD dispersion | 70 | 70 | 70 | 70 | 70 |
| | Oligomer A | 14.5 | 12.5 | 10.5 | 14.5 | 12.5 |
| | 1,6-hexanediol diacrylate | 5.4 | 5.4 | 5.4 | 5.4 | 5.4 |
| | Phenoxyethyl acrylate | 3 | 5 | 7 | | |
| | Bisphenol A diacrylate | | | | 3 | 5 |
| | Methylhydroquinone | 0.1 | 0.1 | 0.1 | 0.1 | 0.1 |
| | Ethyl(2,4,6-trimethylbenzoyl) phenylphospinate | 2 | 2 | 2 | 2 | 2 |
| | Titanium dioxide | 5 | 5 | 5 | 5 | 5 |

**Table 1B**

| | Category | Comparative Example 1-1 | Comparative Example 1-2 | Comparative Example 1-3 |
|---|---|---|---|---|
| Composition | QD dispersion | 70 | 70 | 70 |
| | Oligomer A | 17.5 | 10.5 | |
| | 1,6-hexanediol diacrylate | 5.4 | 12.4 | 22.9 |
| | Phenoxyethyl acrylate | | | |
| | Bisphenol A diacrylate | | | |
| | Methylhydroquinone | 0.1 | 0.1 | 0.1 |
| | Ethyl(2,4,6-trimethylbenzoyl) phenylphospinate | 2 | 2 | 2 |
| | Titanium dioxide | 5 | 5 | 5 |

**Table 1C**

| | Category | Example 2-1 | Comparative Example 2-1 | Comparative Example 2-2 |
|---|---|---|---|---|
| Composition | QD dispersion | 46.5 | 46.5 | 46.5 |
| | Oligomer A | 35.5 | 35.5 | |
| | 1,6-hexanediol diacrylate | 5.9 | 10.9 | 46.4 |
| | Phenoxyethyl acrylate | | | |
| | Bisphenol A diacrylate | 5 | | |
| | Methylhydroquinone | 0.1 | 0.1 | 0.1 |
| | Ethyl(2,4,6-trimethylbenzoyl) phenylphospinate | 2 | 2 | 2 |
| | Titanium dioxide | 5 | 5 | 5 |

### Experimental Example 1. Evaluation of Light Conversion Rate and Light Absorption of Cured Product of Quantum Dot

1) The green quantum dot compositions of Examples 1-1 to 1-5 and Comparative Examples 1-1 to 1-3 were applied to a 2 cm x 2 cm glass substrate to a thickness of 10 µm by using a spin coater (Mikasa, Opticoat MS-A150) and cured at 4000 mJ/cm² by using an LED curing device with a wavelength of 395 nm to prepare a cured film. Subsequently, a single film sample with a size of 2 cm x 2 cm was loaded in an integrating sphere device (QE-2100, Otsuka electronics) to measure initial light absorption and light conversion rates (QE) after curing. Then, the resultant was heat-treated (post-bake) in a nitrogen atmosphere at 180 °C for 30 minutes and light conversion rates (QE) thereof were measured. The results are shown in Tables 2A and 2B below.

**Table 2A**

| | Thickness (µm) | Light absorption (%) | Light conversion rate (after curing) (%) |
|---|---|---|---|
| Example 1-1 | 9.8 | 85.0 | 35.6 |
| Example 1-2 | 9.8 | 85.4 | 36.1 |
| Example 1-3 | 9.7 | 85.7 | 36.4 |
| Example 1-4 | 10.1 | 85.7 | 35.3 |
| Example 1-5 | 10.0 | 85.7 | 35.8 |
| Comparative Example 1-1 | 10.0 | 85.2 | 35.5 |
| Comparative Example 1-2 | 10.0 | 86.3 | 34.1 |
| Comparative Example 1-3 | 10.0 | 87.1 | 33.4 |

**Table 2B**

| | Light conversion rate (after curing+heat treatment) (%) | Wavelength (nm) | FWHM (nm) |
|---|---|---|---|
| Example 1-1 | 34.3 | 533.4 | 35.8 |
| Example 1-2 | 34.6 | 533.4 | 36.0 |
| Example 1-3 | 35.0 | 533.5 | 36.2 |
| Example 1-4 | 35.0 | 533.5 | 35.8 |
| Example 1-5 | 35.3 | 533.6 | 35.9 |
| Comparative Example 1-1 | 33.8 | 533.6 | 35.9 |
| Comparative Example 1-2 | 32.5 | 533.6 | 36.0 |
| Comparative Example 1-3 | 31.8 | 533.5 | 35.8 |

The cured films according to Examples 1-1 to 1-5 and Comparative Examples 1-1 to 1-3 were prepared with a uniform thickness within a range of about 0.3 µm to about 10 µm.

All of Examples 1-1 to 1-5 exhibited light absorptions not less than 85 % and light conversion rates not less than 34 % indicating excellent optical properties.

For example, as the amount of phenoxyethyl acrylate increased, the light conversion rates increased from 34.3 % to 35.0 % in Examples 1-1 to 1-3. As the amount of bisphenol A diacrylate increased, the light conversion rates increased from 35.0 % to 35.3 % in Examples 1-4 to 1-5. On the contrary, in Comparative Examples 1-1 to 1-3 in which the quantum dot composition did not include the aromatic monomer having an aromatic ring such as a phenoxy group, a phenol group, or a phenyl group, the light absorptions were not less than 85 % but the light conversion rates were from 31.8 % to 33.8 % indicating relatively low levels.

Therefore, because excellent optical properties were maintained according to Examples 1-1 to 1-5 before and after heat treatment, light-emitting elements or display devices including those of Examples 1-1 to 1-5 may have excellent optical properties maintained for a longer period of time compared to light-emitting elements or display devices including those of Comparative Examples 1-1 to 1-3.

2) After preparing cured films in the same manner as described above using the red quantum dot compositions prepared in Example 2-1 and Comparative Examples 2-1 and 2-2, light absorptions and light conversion rates were measured. Also, after performing heat treatment in the same manner as described above, light conversion rates were measured. The results are shown in Tables 3A and 3B below.

**Table 3A**

| | Thickness (µm) | Light absorption (%) | Light conversion rate (after curing) (%) |
|---|---|---|---|
| Example 2-1 | 10.1 | 88.1 | 40.5 |
| Comparative Example 2-1 | 9.9 | 87.8 | 39.2 |
| Comparative Example 2-2 | 10.0 | 88.9 | 35.8 |

**Table 3B**

| | Light conversion rate (after curing+heat treatment) (%) | Wavelength (nm) | FWHM (nm) |
|---|---|---|---|
| Example 2-1 | 41.4 | 645.6 | 38.2 |
| Comparative Example 2-1 | 40.1 | 645.7 | 38.0 |
| Comparative Example 2-2 | 36.6 | 645.6 | 38.1 |

All light absorptions were from about 88 % to about 89 %. While the light conversion rate of Example 2-1 was 41.4 %, the light conversion rate of Comparative Example 2-1 not including bisphenol A diacrylate that is an aromatic monomer was slightly decreased to 40.1 %, and a lower light conversion rate of 36.6 % was observed in Comparative Example 2-2 not including the bisphenol A diacrylate nor the oligomer.

Therefore, because excellent optical properties were maintained according to Example 2-1 before and after heat treatment, light-emitting elements or display devices including that of Example 2-1 may have excellent optical properties maintained for a longer period of time compared to light-emitting elements or display devices including those of Comparative Examples 2-1 and 2-2.

### Experimental Example 2. Evaluation of Viscosity of Quantum Dot Composition

Viscosity of the green quantum dot compositions according to Examples 1-1 to 1-5 and Comparative Examples 1-1 to 1-3 was measured. In this regard, viscosity was measured at room temperature (25°C) by using a rheometer (Thermo Scientific, HAAKE MARS).

Also, viscosity of the red quantum dot compositions of Example 2-1 and Comparative Examples 2-1 and 2-2 was measured in the same manner. The results are shown in Tables 4A and 4B below.

**Table 4A**

| | Example 1-1 | Example 1-2 | Example 1-3 | Example 1-4 | Example 1-5 | Comparative Example 1-1 | Comparative Example 1-2 | Comparative Example 1-3 |
|---|---|---|---|---|---|---|---|---|
| Viscosity (cps, 25°C) | 203 | 174 | 151 | 289 | 232 | 344 | 65 | 35 |

**Table 4B**

| | Example 2-1 | Comparative Example 2-1 | Comparative Example 2-2 |
|---|---|---|---|
| Viscosity (cps, 25°C) | 582 | 552 | 26 |

The green quantum dot compositions according to the examples exhibited viscosities of about 151 cps to about 289 cps and the red quantum dot compositions according to the examples exhibited viscosities of about 582 cps indicating suitable viscosities not only for inkjet printing but also for EHD inkjet printing.

On the contrary, those of Comparative Examples 1-3 and 2-2 not including the oligomer exhibited low viscosities of about 35 cps and 26 cps indicating that they are not suitable for EHD inkjet printing.

In addition, although Comparative Examples 1-1 and 2-1 not including the aromatic monomer were suitable in terms of the viscosity but there may be difficulty in actual application, considering the results of Experimental Examples 1 and 2.

### Experimental Example 3. Evaluation of Electrohydrodynamic (EHD) Inkjet Printing (Ink jettability)

Ink jettability (jetting performance) of the green quantum dot compositions of Examples 1-1 to 1-5 and Comparative Examples 1-1 to 1-3 was measured. For example, EHD ink jettability was evaluated by using an iEHD printer (ENJET) with an inner nozzle diameter of 75 µm.

In addition, ink jettability of the red quantum dot compositions of Examples 2-1 and 2-2 and Comparative Example 2-1 was measured in the same manner. The results are shown in Tables 5A and 5B below.

**Table 5A**

| | Example 1-1 | Example 1-2 | Example 1-3 | Example 1-4 | Example 1-5 |
|---|---|---|---|---|---|
| Ink jettability | good | good | good | good | good |

**Table 5B**

| | Comparative Example 1-1 | Comparative Example 1-2 | Comparative Example 1-3 | Example 2-1 | Comparative Example 2-1 | Comparative Example 2-2 |
|---|---|---|---|---|---|---|
| Inkjettability | good | poor | poor | good | good | poor |

It was confirmed that all of the green quantum dot compositions exhibited good EHD inkjet printing performance of about 1.5 kV delta voltage - 0.5 kV to - 2.0 kV without nozzle clogging, and the red quantum dot compositions also exhibited good EHD inkjet printing performance of about 2.2 kV delta voltage -0.6 kV to -2.8 kV without nozzle clogging.

However, those of Comparative Examples 1-2, 1-3 and 2-2 having viscosities not more than 100 cps exhibited a problem that jetting was not properly performed in a desired area during EHD printing due to low viscosity.

The disclosure is not limited to the above-described embodiments, and it will be understood by those of ordinary skill in the art that various changes in form and details may be made therein without departing from the scope of the disclosure as defined by the following claims

Provided are a quantum dot composition having high viscosity suitable for EHD inkjet printing, excellent optical properties, and excellent ink jettability (jetting performance), a manufacturing method thereof, a cured product of the quantum dot composition, and a display device including the same.

The quantum dot composition according to the disclosure have excellent optical properties, high viscosity suitable for EHD inkjet printing, and excellent ink jettability (jetting performance).

Therefore, a light-emitting element and a display device including the quantum dot composition according to the disclosure may have excellent optical properties.

## Claims

1. A quantum dot composition comprising:
quantum dots;
a photopolymerizable monomer; and
an oligomer,
wherein the photopolymerizable monomer comprises a compound including an aromatic ring and wherein the oligomer comprises a compound including a carbon-carbon double bond and a compound including a thiol group.

2. The quantum dot composition of claim 1,
wherein the compound including the aromatic ring comprises a phenoxy group, a phenol group, or a phenyl group.

3. The quantum dot composition of claim 1,
wherein the compound including the aromatic ring comprises phenoxyethyl acrylate, phenoxyethyl methacrylate, ortho-phenyl phenoxyethyl acrylate, phenoxy benzylacrylate, benzyl acrylate, benzyl methacrylate, biphenylmethyl acrylate, bisphenol A diacrylate, bisphenol A dimethacrylate, bisphenol A ethoxylate diacrylate, bisphenol A glycerolate diacrylate, or bisphenol F ethoxylate diacrylate.

4. The quantum dot composition of claim 1,
wherein the photopolymerizable monomer further comprises an acrylate-based monomer.

5. The quantum dot composition of claim 1,
wherein the compound including the carbon-carbon double bond comprises one or more phenol group-containing compounds.

6. The quantum dot composition of claim 1,
wherein the quantum dots are surface-modified by a first ligand represented by Formula 1 below; and
a second ligand including 3 to 40 carbon atoms and including a carboxyl group: 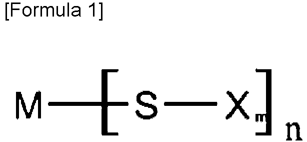 wherein in Formula 1,
M is a divalent to quadrivalent metal,
m is an integer from 1 to 4, each X is independently a C3-C20 organic group, and
n is an integer from 2 to 4.

7. The quantum dot composition of **claim** 1,
wherein a viscosity of the quantum dot composition is in a range of about 150 cps to about 600 cps at room temperature.

8. Use of the quantum dot composition of claim 1for electrohydrodynamic inkjet printing.

9. A method of manufacturing a quantum dot composition, the method comprising:
surface-modifying quantum dots and dispersing the quantum dots in a photopolymerizable monomer to obtain a quantum dot dispersion; and
additionally adding an oligomer and a photopolymerizable monomer to the quantum dot dispersion,
wherein the photopolymerizable monomer comprises a compound including an aromatic ring and wherein the oligomer is prepared by mixing a compound including a carbon-carbon double bond and a compound including a thiol group.

10. The method of claim 9,
wherein the compound including the aromatic ring comprises a phenoxy group, a phenol group, or a phenyl group.

11. The method of claim 9,
wherein the compound including the aromatic ring is phenoxyethyl acrylate, phenoxyethyl methacrylate, ortho-phenyl phenoxyethyl acrylate, phenoxy benzylacrylate, benzyl acrylate, benzyl methacrylate, biphenylmethyl acrylate, bisphenol A diacrylate, bisphenol A dimethacrylate, bisphenol A ethoxylate diacrylate, bisphenol A glycerolate diacrylate, or bisphenol F ethoxylate diacrylate.

12. The method of claim 9,
wherein the photopolymerizable monomer further comprises an acrylate-based monomer.

13. The method of claim 9,
wherein the surface-modifying of the quantum dots comprises primary surface modification performed by adding a first ligand represented by Formula 1 below, and secondary surface modification performed by adding a second ligand including 3 to 40 carbon atoms and including a carboxyl group: 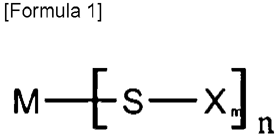 in Formula 1,
M is a divalent to quadrivalent metal,
m is an integer from 1 to 4, each X is independently a C3-C20 organic group, and
n is an integer from 2 to 4.

14. The method of claim 9,
wherein the surface-modifying of the quantum dots comprises simultaneously adding a first ligand represented by Formula 1 below and adding a second ligand including 3 to 40 carbon atoms and including a carboxyl group: 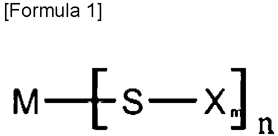 in Formula 1,
M is a divalent to quadrivalent metal,
m is an integer from 1 to 4, each X is independently a C3-C20 organic group, and
n is an integer from 2 to 4.

15. The method of claim 9,
wherein the compound including the carbon-carbon double bond comprises at least one phenol group-containing compound.

16. The method of claim 9,
wherein the oligomer comprises a thermal initiator and a polymerization inhibitor, and
the oligomer is prepared by stirring and polymerizing at room temperature before being mixed with the quantum dot dispersion.

17. A cured film prepared by using the quantum dot composition of claim 1.

18. A light-emitting element comprising the quantum dot composition of claim 1.

19. A display device comprising the light-emitting element of claim 18.

20. A display device, comprising:
a light-emitting element, the light-emitting element comprising:
a quantum dot composition comprising:
quantum dots;
a photopolymerizable monomer; and
an oligomer,
wherein:
the photopolymerizable monomer comprises a compound including an aromatic ring and wherein the oligomer comprises a compound including a carbon-carbon double bond and a compound including a thiol group, and
the quantum dots are surface-modified by a first ligand represented by Formula 1 below and a second ligand including 3 to 40 carbon atoms and including a carboxyl group: 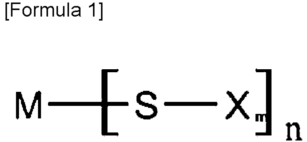 wherein in Formula 1, M is a divalent to quadrivalent metal, m is an integer from 1 to 4, each X is independently a C3-C20 organic group and n is an integer from 2 to 4.

## Patentansprüche

1. Quantenpunktzusammensetzung, umfassend:
Quantenpunkte;
ein photopolymerisierbares Monomer; und
ein Oligomer,
wobei das photopolymerisierbare Monomer eine Verbindung, die einen aromatischen Ring enthält, umfasst und wobei das Oligomer eine Verbindung, die eine Kohlenstoff-Kohlenstoff-Doppelbindung enthält, und eine Verbindung, die eine Thiolgruppe enthält, umfasst.

2. Quantenpunktzusammensetzung nach Anspruch 1,
wobei die Verbindung, die den aromatischen Ring enthält, eine Phenoxygruppe, eine Phenolgruppe oder eine Phenylgruppe umfasst.

3. Quantenpunktzusammensetzung nach Anspruch 1,
wobei die Verbindung, die den aromatischen Ring enthält, Phenoxyethylacrylat, Phenoxyethylmethacrylat, Ortho-Phenylphenoxyethylacrylat, Phenoxybenzylacrylat, Benzylacrylat, Benzylmethacrylat, Biphenylmethylacrylat, Bisphenol-A-diacrylat, Bisphenol-A-dimethacrylat, Bisphenol-A-ethoxylatdiacrylat, Bisphenol-A-glycerolatdiacrylat oder Bisphenol-F-ethoxylatdiacrylat umfasst.

4. Quantenpunktzusammensetzung nach Anspruch 1,
wobei das photopolymerisierbare Monomer ferner ein Monomer auf Acrylatbasis umfasst.

5. Quantenpunktzusammensetzung nach Anspruch 1,
wobei die Verbindung, die die Kohlenstoff-Kohlenstoff-Doppelbindung enthält, eine oder mehrere Phenolgruppen enthaltende Verbindungen umfasst.

6. Quantenpunktzusammensetzung nach Anspruch 1,
wobei die Quantenpunkte oberflächenmodifiziert sind durch einen ersten Liganden, dargestellt durch Formel 1 unten; und
einen zweiten Liganden, der 3 bis 40 Kohlenstoffatome enthält und eine Carboxylgruppe enthält: 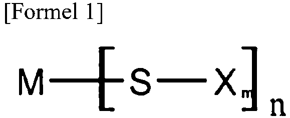
wobei, in Formel 1,
M ein zwei- bis vierwertiges Metall ist,
m eine Ganzzahl von 1 bis 4 ist, jedes X unabhängig eine organische C3-C20-Gruppe ist und
n eine Ganzzahl von 2 bis 4 ist.

7. Quantenpunktzusammensetzung nach Anspruch 1,
wobei eine Viskosität der Quantenpunktzusammensetzung bei Raumtemperatur in einem Bereich von etwa 150 cps bis etwa 600 cps liegt.

8. Verwendung der Quantenpunktzusammensetzung nach Anspruch 1 für elektrohydrodynamisches Tintenstrahldrucken.

9. Verfahren zum Herstellen einer Quantenpunktzusammensetzung, wobei das Verfahren Folgendes umfasst:
Oberflächenmodifizieren von Quantenpunkten und Dispergieren der Quantenpunkte in einem photopolymerisierbaren Monomer, um eine Quantenpunkt-Dispersion zu erlangen; und
zusätzliches Hinzufügen eines Oligomers und eines photopolymerisierbaren Monomers zu der Quantenpunkt-Dispersion,
wobei das photopolymerisierbare Monomer eine Verbindung, die einen aromatischen Ring enthält, umfasst und wobei das Oligomer durch Mischen einer Verbindung, die eine Kohlenstoff-Kohlenstoff-Doppelbindung enthält, und einer Verbindung, die eine Thiolgruppe enthält, zubereitet wird.

10. Verfahren nach Anspruch 9,
wobei die Verbindung, die den aromatischen Ring enthält, eine Phenoxygruppe, eine Phenolgruppe oder eine Phenylgruppe umfasst.

11. Verfahren nach Anspruch 9,
wobei die Verbindung, die den aromatischen Ring enthält, Phenoxyethylacrylat, Phenoxyethylmethacrylat, Ortho-Phenylphenoxyethylacrylat, Phenoxybenzylacrylat, Benzylacrylat, Benzylmethacrylat, Biphenylmethylacrylat, Bisphenol-A-diacrylat, Bisphenol-A-dimethacrylat, Bisphenol-A-ethoxylatdiacrylat, Bisphenol-A-glycerolatdiacrylat oder Bisphenol-F-ethoxylatdiacrylat ist.

12. Verfahren nach Anspruch 9,
wobei das photopolymerisierbare Monomer ferner ein Monomer auf Acrylatbasis umfasst.

13. Verfahren nach Anspruch 9,
wobei das Oberflächenmodifizieren der Quantenpunkte eine primäre Oberflächenmodifikation, durchgeführt durch Hinzufügen eines ersten Liganden, dargestellt durch Formel 1 unten, und eine sekundäre Oberflächenmodifikation, durchgeführt durch Hinzufügen eines zweiten Liganden, der 3 bis 40 Kohlenstoffatome enthält und eine Carboxylgruppe enthält, umfasst: 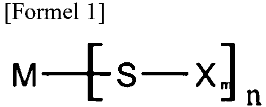 wobei in Formel 1
M ein zwei- bis vierwertiges Metall ist,
m eine Ganzzahl von 1 bis 4 ist, jedes X unabhängig eine organische C3-C20-Gruppe ist und
n eine Ganzzahl von 2 bis 4 ist.

14. Verfahren nach Anspruch 9,
wobei das Oberflächenmodifizieren der Quantenpunkte gleichzeitiges Hinzufügen eines ersten Liganden, dargestellt durch Formel 1 unten, und Hinzufügen eines zweiten Liganden, der 3 bis 40 Kohlenstoffatome enthält und eine Carboxylgruppe enthält, umfasst: 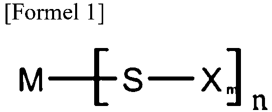 wobei in Formel 1
M ein zwei- bis vierwertiges Metall ist,
m eine Ganzzahl von 1 bis 4 ist, jedes X unabhängig eine organische C3-C20-Gruppe ist und
n eine Ganzzahl von 2 bis 4 ist.

15. Verfahren nach Anspruch 9,
wobei die Verbindung, die die Kohlenstoff-Kohlenstoff-Doppelbindung enthält, mindestens eine Phenolgruppen enthaltende Verbindungen umfasst.

16. Verfahren nach Anspruch 9,
wobei das Oligomer einen thermischen Initiator und einen Polymerisationshemmer umfasst und
das Oligomer durch Rühren und Polymerisieren bei Raumtemperatur zubereitet wird, bevor es mit der Quantenpunkt-Dispersion gemischt wird.

17. Gehärteter Film, angefertigt unter Verwendung der Quantenpunktzusammensetzung nach Anspruch 1.

18. Lichtemittierendes Element, umfassend die Quantenpunktzusammensetzung nach Anspruch 1.

19. Anzeigevorrichtung, umfassend das lichtemittierende Element nach Anspruch 18.

20. Anzeigevorrichtung, umfassend:
ein lichtemittierendes Element, wobei das lichtemittierende Element Folgendes umfasst:
eine Quantenpunktzusammensetzung, die Folgendes umfasst:
Quantenpunkte;
ein photopolymerisierbares Monomer; und
ein Oligomer,
wobei:
das photopolymerisierbare Monomer eine Verbindung, die einen aromatischen Ring enthält, umfasst und wobei das Oligomer eine Verbindung, die eine Kohlenstoff-Kohlenstoff-Doppelbindung enthält, und eine Verbindung, die eine Thiolgruppe enthält, umfasst, und
die Quantenpunkte oberflächenmodifiziert sind durch einen ersten Liganden, dargestellt durch Formel 1 unten, und einen zweiten Liganden, der 3 bis 40 Kohlenstoffatome enthält und eine Carboxylgruppe enthält: 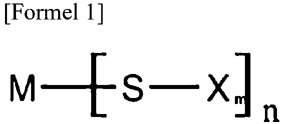
wobei in Formel 1 M ein zweiwertiges bis vierwertiges Metall ist, m eine Ganzzahl von 1 bis 4 ist, jedes X unabhängig eine organische C3-C20-Gruppe ist und n eine Ganzzahl von 2 bis 4 ist.

## Revendications

1. Composition de points quantiques comprenant :
des points quantiques ;
un monomère photopolymérisable ; et
un oligomère,
dans laquelle le monomère photopolymérisable comprend un composé comprenant un cycle aromatique et dans laquelle l'oligomère comprend un composé comprenant une double liaison carbone-carbone et un composé comprenant un groupe thiol.

2. Composition de points quantiques de la revendication 1,
dans laquelle le composé comprenant le cycle aromatique comprend un groupe phénoxy, un groupe phénol ou un groupe phényle.

3. Composition de points quantiques de la revendication 1,
dans laquelle le composé comprenant le cycle aromatique comprend l'acrylate de phénoxyéthyle, le méthacrylate de phénoxyéthyle, l'acrylate d'ortho-phénylphénoxyéthyle, l'acrylate de phénoxybenzyle, l'acrylate de benzyle, le méthacrylate de benzyle, l'acrylate de biphénylméthyle, le diacrylate de bisphénol A, le diméthacrylate de bisphénol A, le diacrylate d'éthoxylate de bisphénol A, le diacrylate de glycérolate de bisphénol A ou le diacrylate d'éthoxylate de bisphénol F.

4. Composition de points quantiques de la revendication 1,
dans laquelle le monomère photopolymérisable comprend en outre un monomère à base d'acrylate.

5. Composition de points quantiques de la revendication 1,
dans laquelle le composé comprenant la double liaison carbone-carbone comprend un ou plusieurs composés contenant un groupe phénol.

6. Composition de points quantiques de la revendication 1,
dans laquelle les points quantiques sont modifiés en surface par un premier ligand représenté par la Formule 1 ci-dessous ; et
un second ligand comprenant 3 à 40 atomes de carbone et comprenant un groupe carboxyle : 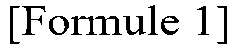 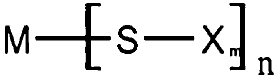 où, dans la Formule 1,
M est un métal divalent à quadrivalent,
m est un entier de 1 à 4, chaque X est indépendamment un groupe organique en C3-C20, et
n est un entier de 2 à 4.

7. Composition de points quantiques de la revendication 1,
dans laquelle une viscosité de la composition de points quantiques est comprise dans une plage d'environ 150 cps à environ 600 cps à température ambiante.

8. Utilisation de la composition de points quantiques de la revendication 1 pour une impression par jet d'encre électrohydrodynamique.

9. Procédé de fabrication d'une composition de points quantiques, le procédé comprenant :
la modification de surface de points quantiques et la dispersion des points quantiques dans un monomère photopolymérisable pour obtenir une dispersion de points quantiques ; et
l'ajout supplémentaire d'un oligomère et d'un monomère photopolymérisable à la dispersion de points quantiques,
dans lequel le monomère photopolymérisable comprend un composé comprenant un cycle aromatique et dans lequel l'oligomère est préparé en mélangeant un composé comprenant une double liaison carbone-carbone et un composé comprenant un groupe thiol.

10. Procédé de la revendication 9,
dans lequel le composé comprenant le cycle aromatique comprend un groupe phénoxy, un groupe phénol ou un groupe phényle.

11. Procédé de la revendication 9,
dans lequel le composé comprenant le cycle aromatique est l'acrylate de phénoxyéthyle, le méthacrylate de phénoxyéthyle, l'acrylate d'ortho-phénylphénoxyéthyle, l'acrylate de phénoxybenzyle, l'acrylate de benzyle, le méthacrylate de benzyle, l'acrylate de biphénylméthyle, le diacrylate de bisphénol A, le diméthacrylate de bisphénol A, le diacrylate d'éthoxylate de bisphénol A, le diacrylate de glycérolate de bisphénol A ou le diacrylate d'éthoxylate de bisphénol F.

12. Procédé de la revendication 9,
dans lequel le monomère photopolymérisable comprend en outre un monomère à base d'acrylate.

13. Procédé de la revendication 9,
dans lequel la modification de surface des points quantiques comprend une modification de surface primaire effectuée en ajoutant un premier ligand représenté par la Formule 1 ci-dessous, et une modification de surface secondaire effectuée en ajoutant un second ligand comprenant 3 à 40 atomes de carbone et comprenant un groupe carboxyle : 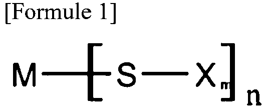 dans la Formule 1,
M est un métal divalent à quadrivalent,
m est un entier de 1 à 4, chaque X est indépendamment un groupe organique en C3-C20, et
n est un entier de 2 à 4.

14. Procédé de la revendication 9,
dans lequel la modification de surface des points quantiques comprend l'ajout simultané d'un premier ligand représenté par la Formule 1 ci-dessous et l'ajout d'un second ligand comprenant 3 à 40 atomes de carbone et comprenant un groupe carboxyle : 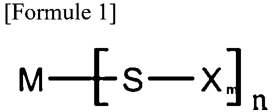 dans la Formule 1,
M est un métal divalent à quadrivalent,
m est un entier de 1 à 4, chaque X est indépendamment un groupe organique en C3-C20, et
n est un entier de 2 à 4.

15. Procédé de la revendication 9,
dans lequel le composé comprenant la double liaison carbone-carbone comprend au moins un composé contenant un groupe phénol.

16. Procédé de la revendication 9,
dans lequel l'oligomère comprend un initiateur thermique et un inhibiteur de polymérisation, et
l'oligomère est préparé par agitation et polymérisation à température ambiante avant d'être mélangé à la dispersion de points quantiques.

17. Film durci préparé en utilisant la composition de points quantiques de la revendication 1.

18. Élément électroluminescent comprenant la composition de points quantiques de la revendication 1.

19. Dispositif d'affichage comprenant l'élément électroluminescent de la revendication 18.

20. Dispositif d'affichage, comprenant :
un élément électroluminescent, l'élément électroluminescent comprenant :
une composition de points quantiques comprenant :
des points quantiques ;
un monomère photopolymérisable ; et
un oligomère,
dans lequel :
le monomère photopolymérisable comprend un composé comprenant un cycle aromatique et dans lequel l'oligomère comprend un composé comprenant une double liaison carbone-carbone et un composé comprenant un groupe thiol, et
les points quantiques sont modifiés en surface par un premier ligand représenté par la Formule 1 ci-dessous et un second ligand comprenant 3 à 40 atomes de carbone et comprenant un groupe carboxyle : 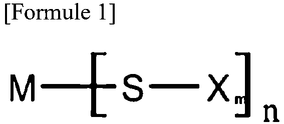
où, dans la Formule 1, M est un métal divalent à quadrivalent, m est un entier de 1 à 4, chaque X est indépendamment un groupe organique en C3-C20 et n est un entier de 2 à 4.
